# EUROPEAN PATENT SPECIFICATION

(11) **EP 4 597 550 B1**
(45) Date of publication and mention of the grant of the patent: **30.09.2026**
(21) Application number: 24155761.0
(22) Date of filing: 05.02.2024
(51) Int. Cl.: H10W 76/12, H10W 76/15, H10W 90/00, H10W 95/00

(54) **HOUSING FOR A SEMICONDUCTOR MODULE, SEMICONDUCTOR MODULE COMPRISING A HOUSING, AND METHOD FOR ASSEMBLING A SEMICONDUCTOR MODULE COMPRISING A HOUSING**
GEHÄUSE FÜR EIN HALBLEITERMODUL, HALBLEITERMODUL MIT EINEM GEHÄUSE UND VERFAHREN ZUM MONTIEREN EINES HALBLEITERMODULS MIT EINEM GEHÄUSE
BOÎTIER POUR UN MODULE SEMI-CONDUCTEUR, MODULE SEMI-CONDUCTEUR COMPRENANT UN BOÎTIER ET PROCÉDÉ D'ASSEMBLAGE D'UN MODULE SEMI-CONDUCTEUR COMPRENANT UN BOÎTIER

(43) Date of publication of application: 06.08.2025
(73) Proprietor: Infineon Technologies AG, 85579 Neubiberg (DE)
(72) Inventor: HEGEDÜS, Ákos Ferenc, 1132 Budapest (HU); BUCSI, Balázs, 1172 Budapest (HU); HELLER, Zoltán, 1193 Budapest (HU)
(74) Representative: Westphal, Mussgnug & Partner, Patentanwälte mbB

(56) References cited:
- US-A1- 2018 182 678
- US-B1- 6 184 514

## Description

### TECHNICAL FIELD

The instant disclosure relates to a housing for a semiconductor module, to a semiconductor module comprising a housing, and to a method for assembling a semiconductor module comprising a housing.

### BACKGROUND

Document US 2018/182678 A1 discloses a case and a semiconductor device including the case. The case includes a first member and a second member that is engaged with the first member to form an accommodation space inside the case, and the first member has a protruding portion extending from the first member side toward the second member side and having an end portion crushed from the opposite side of the first member to fix the second member to the first member.

Document US 6 184 514 B1 discloses a cover designed to be mounted on a supporting substrate in which a sensor is mounted. The substrate has a generally planar surface with the image sensor being mounted below the generally planar surface. Cover includes a body portion which extends over the image sensor and has means for removably mounting and demounting the cover from the substrate. The cover further includes a window area such that use and/or test of said sensor may occur through said window when the cover is mounted to said substrate.

Power semiconductor module arrangements often include at least one semiconductor substrate arranged in a housing. A semiconductor arrangement including a plurality of controllable semiconductor elements (e.g., two IGBTs in a half-bridge configuration) or non-controllable semiconductor elements (e.g., arrangements of diodes) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. The second metallization layer may optionally be attached to a base plate. Semiconductor elements may be electrically coupled with other semiconductor elements, with the first metallization layer and/or with any other components of the semiconductor module arrangement by means of electrical connections such as, e.g., bonding wires or ribbons, for example. The semiconductor elements, electrical connections and/or any other components arranged on the at least one substrate and inside the housing may degrade and/or fail over the lifetime of the semiconductor module arrangement. In this respect, it is usually not possible to predict when a component arranged inside the housing might fail. Failure of a single component or of several components may lead to the failure of the entire semiconductor module arrangement.

There is a need for a housing, a semiconductor module arrangement comprising a housing, and a method for assembling a semiconductor module comprising a housing that allow performing failure analysis and failure prediction in an easy and cost-effective way.

### SUMMARY

A housing for a semiconductor module arrangement includes sidewalls defining a first volume, a first cover element attached to or integrally formed with the sidewalls, wherein the first cover element includes an opening, such that it only partly covers the first volume, and a second cover element, wherein the second cover element is removably mounted on the first cover element such that it can be removed from the first cover element without destroying any of the first cover element and the second cover element, and such that it entirely covers the opening in the first cover element.

A semiconductor module arrangement includes a substrate comprising a dielectric insulation layer, a first metallization layer attached to the dielectric insulation layer, and a second metallization layer attached to the dielectric insulation layer, wherein the dielectric insulation layer is disposed between the first and second metallization layers, the substrate having a first surface, the first surface being a top surface of the substrate on which semiconductor bodies and any other components are mounted, and a housing according to embodiments of the disclosure, wherein the housing is arranged such that its sidewalls surround at least the first metallization layer of the substrate, and the first volume is defined adjacent to the first surface of the substrate.

A method for assembling a semiconductor module arrangement includes arranging a housing such that the sidewalls of the housing surround a substrate and define the first volume adjacent to a first surface of the substrate, and removing the second cover element from the first cover element such that the opening in the first cover element is uncovered.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement.
Figure 2 is a three-dimensional view of a housing for a semiconductor module arrangement according to embodiments of the disclosure.
Figure 3 is another three-dimensional view of a housing for a semiconductor module arrangement according to embodiments of the disclosure.
Figure 4 is a three-dimensional view of a housing for a semiconductor module arrangement according to further embodiments of the disclosure.
Figure 5 is a three-dimensional view of a housing for a semiconductor module arrangement according to even further embodiments of the disclosure.
Figure 6 is a cross-sectional view of a semiconductor module arrangement according to embodiments of the disclosure.
Figure 7 is a cross-sectional view of a semiconductor module arrangement according to further embodiments of the disclosure.
Figure 8 is a cross-sectional view of a semiconductor module arrangement according to even further embodiments of the disclosure.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description, as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

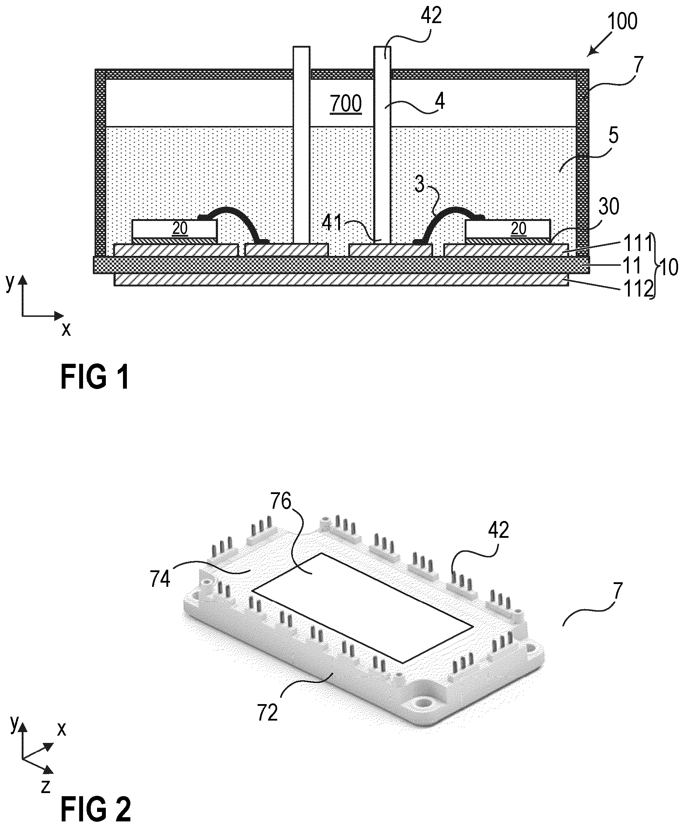

Referring to Figure 1, a cross-sectional view of a power semiconductor module arrangement 100 is illustrated. The power semiconductor module arrangement 100 includes a housing 7 and a semiconductor substrate 10. The semiconductor substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The semiconductor substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: Al₂O₃, AIN, SiC, BeO or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AlN, or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin.

The semiconductor substrate 10 is arranged in a housing 7. In the example illustrated in Figure 1, the semiconductor substrate 10 forms a ground surface of the housing 7, while the housing 7 itself solely comprises sidewalls and a cover. This is, however, only an example. It is also possible that the housing 7 further comprises a ground surface and the semiconductor substrate 10 be arranged inside the housing 7. According to another example, the semiconductor substrate 10 may be mounted on a base plate (not illustrated). In some power semiconductor module arrangements 100, more than one semiconductor substrate 10 is arranged on a single base plate. The base plate may form a ground surface of the housing 7, for example. The top of the housing 7 can either be a separate cover or lid that can be removed from the sidewalls, or may be formed integrally with at least the sidewalls of the housing 7. In the latter case, the top and at least the sidewalls of the housing 7 may be formed as a single piece such that the top cannot be removed from the sidewalls without destroying the housing 7.

One or more semiconductor bodies 20 may be arranged on the semiconductor substrate 10. Each of the semiconductor bodies 20 arranged on the semiconductor substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable controllable or non-controllable semiconductor element.

The one or more semiconductor bodies 20 may form a semiconductor arrangement on the semiconductor substrate 10. In Figure 1, only two semiconductor bodies 20 are exemplarily illustrated. The second metallization layer 112 of the semiconductor substrate 10 in Figure 1 is a continuous layer. The first metallization layer 111 is a structured layer in the example illustrated in Figure 1. "Structured layer" means that the first metallization layer 111 is not a continuous layer, but includes recesses between different sections of the layer. Such recesses are schematically illustrated in Figure 1. The first metallization layer 111 in this example includes four different sections. Different semiconductor bodies 20 may be mounted to the same or to different sections of the first metallization layer 111. Different sections of the first metallization layer may have no electrical connection or may be electrically connected to one or more other sections using, e.g., bonding wires 3. Electrical connections 3 may also include connection plates or conductor rails, for example, to name just a few examples. The one or more semiconductor bodies 20 may be electrically and mechanically connected to the semiconductor substrate 10 by an electrically conductive connection layer 30. Such an electrically conductive connection layer may be a solder layer, a layer of an electrically conductive adhesive, or a layer of a sintered metal powder, e.g., a sintered silver powder, for example.

The power semiconductor module arrangement 100 illustrated in Figure 1 further includes terminal elements 4. The terminal elements 4 are electrically connected to the first metallization layer 111 and provide an electrical connection between the inside and the outside of the housing 7. The terminal elements 4 may be electrically connected to the first metallization layer 111 with a first end 41, while a second end 42 of the terminal elements 4 protrudes out of the housing 7. The terminal elements 4 may be electrically contacted from the outside at their second end 42. The terminal elements 4 illustrated in Figure 1, however, are only examples. Terminal elements 4 may be implemented in any other way and may be arranged at any other position. For example, one or more terminal elements 4 may be arranged close to or adjacent to the sidewalls of the housing 7, similar to what is illustrated in Figure 2. Any other suitable implementation is possible. The terminal elements 4 may consist of or include a metal such as copper, aluminum, gold, silver, or any alloys thereof, for example. The terminal elements 4 may be electrically and mechanically connected to the semiconductor substrate 10 by an electrically conductive connection layer (not specifically illustrated for the terminal elements 4). Such an electrically conductive connection layer generally may be a solder layer, a layer of an electrically conductive adhesive, or a layer of a sintered metal powder, e.g., a sintered silver powder, for example. In other power semiconductor module arrangements, terminal elements 4, instead of directly on the substrate 10, may alternatively or additionally be arranged on semiconductor bodies 20 or on any other metallic components of the power semiconductor module arrangement 100. That is, terminal elements 4 do not necessarily have to be connected to the first metallization layer 111 of the substrate 10.

Conventional power semiconductor module arrangements 100 generally further include a casting compound 5. The casting compound 5 may consist of or include a silicone gel or may be a rigid molding compound, for example. The casting compound 5 may at least partly fill the interior of the housing 7, thereby covering the components and electrical connections that are arranged on the semiconductor substrate 10. The terminal elements 4 may be partly embedded in the casting compound 5. At least their second ends 42, however, are not covered by the casting compound 5 and protrude from the casting compound 5 through the housing 7, to the outside of the housing 7. The casting compound 5 is configured to protect the components and electrical connections inside the power semiconductor module 100, in particular inside the housing 7, from certain environmental conditions and mechanical damage. The casting compound 5, however, is generally optional and can also be omitted.

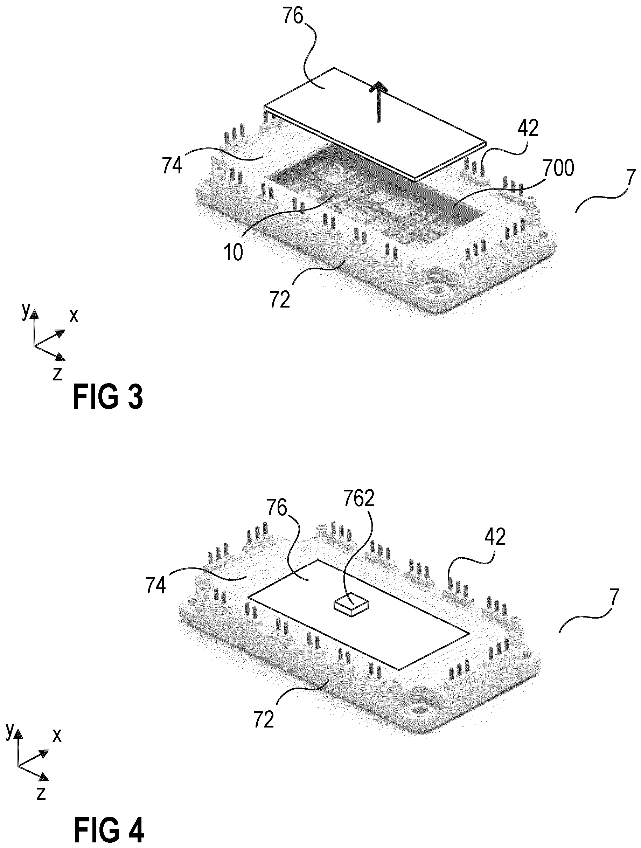

During operation of the semiconductor module 100, the semiconductor bodies 20 may perform a great number of switching operations. That is, they are usually switched on and off regularly during operation of the semiconductor module. Certain semiconductor bodies 20 glow (emit light at a certain wavelength) when being switched on. SiC-MOSFETs, in particular the body diodes of SiC-MOSFETs, for example, glow with a bluish light when being switched on. The intensity of the light emitted by a semiconductor body 20 during the switch-on operation is generally directly proportional to the electric current flowing through the device (i.e. the source-drain current, I_{SD}). In particular, when the I_{SD} increases, the light intensity also increases. That is, the I_{SD} may be determined by determining the light intensity of the light emitted by a semiconductor body 20 when being switched on. The light intensity can be determined by means of optical sensors such as, e.g., photodiodes, or CCD cameras.
The arrangement as illustrated in Figure 1, however, does not easily allow such an optical monitoring of one or more components arranged on the substrate 10. An optical sensor that is used to monitor one or more components of a semiconductor module 100 generally needs to be sufficiently galvanically isolated from any components arranged on the substrate 10. Further, the optical sensor needs to be arranged such that its view on the substrate 10 is unobstructed. These requirements cannot be reliably fulfilled in an arrangement as illustrated in Figure 1, which includes a generally non-transparent housing 7. On the other hand, not every customer of a housing 7 implements an optical monitoring as described above.
Now referring to Figure 2, a housing 7 according to embodiments of the disclosure comprises sidewalls 72 defining a first volume 700 (similar to first volume indicated in Figure 1), a first cover element 74 attached to or integrally formed with the sidewalls 72, wherein the first cover element 74 comprises an opening, such that it only partly covers the first volume 700, and a second cover element 76, wherein the second cover element 76 is configured to be removably mounted on the first cover element 74, wherein, when the second cover element 76 is mounted on the first cover element 74, it entirely covers the opening in the first cover element 74. In the three-dimensional view illustrated in Figure 2, the second cover element 76 is mounted on the first cover element 74 such that the opening in the first cover element 74 is entirely covered and is not visible. Figure 3 schematically illustrates the housing 7 of Figure 2 with the second cover element 76 being removed from the first cover element 74 (indicated by an arrow in Figure 3). In the view illustrated in Figure 3, therefore, the opening in the first cover element 74 is visible. The housing 7 illustrated in Figure 3 is arranged such that the sidewalls 72 of the housing 7 surround at least the first metallization layer 111 of a substrate 10 and define the first volume 700 adjacent to a first surface of the substrate 10. As can be seen, when the second cover element 76 is removed from the opening, the substrate 10 and the components (e.g., semiconductor bodies 20 and/or electrical connections 3) are visible through the opening. The first surface of the substrate 10 is a top surface of the substrate 10 on which the semiconductor bodies 20 and any other components are mounted. The second cover element 76 may consist of the same material or of a different material as the first cover element 74.

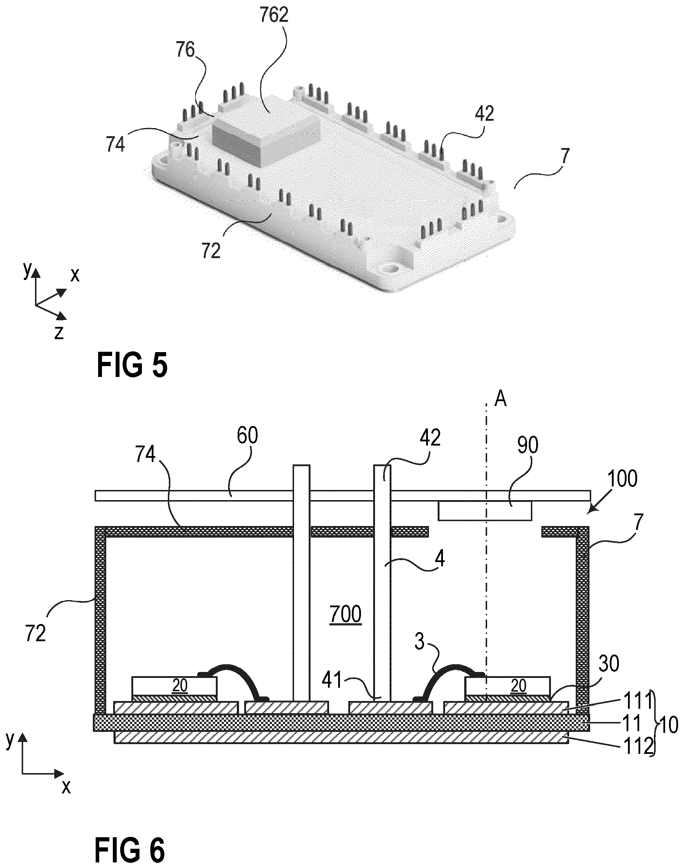

The second cover element 76 may be removed from the first cover element 74 manually or automatically. In order to facilitate the removal of the second cover element 76, the second cover element 76 may comprise a grasping element 762 configured to be grasped by a user or a robotic gripper arm, for example, in order to remove the second cover element 76 from or mount the second cover element 76 on the first cover element 74. A second cover element 76 comprising a grasping element 762 is schematically illustrated in Figure 4. The grasping element 762 may comprise a simple protrusion or knob, for example, as illustrated in Figure 4. The grasping element 762, however, may also be implemented in any other suitable way. Now referring to Figure 5, an alternative implementation of a second cover element 76 and grasping element 762 is schematically illustrated. In the example illustrated in Figure 5, the grasping element 762 is larger as compared to the grasping element 762 illustrated in Figure 4.

The second cover element 76 may be coupled to the first cover element 74 in any suitable way, when it is removably mounted on the first cover element 74. The connection between the second cover element 76 and the first cover element 74 is a removable connection. That is, the second cover element 76 can be removed from the first cover element 74 without destroying any of the first cover element 74 and the second cover element 76. According to one example, the first cover element 74 comprises at least one protrusion extending from the first cover element 74 into the opening, wherein, when the second cover element 76 is mounted on the first cover element 74, the second cover element 76 rests on the at least one protrusion. According to one example, the first cover element 74 comprises one protrusion extending along the entire circumference of the opening. According to other examples, two or more separate protrusions may be arranged along the circumference of the opening. The one or more protrusions prevent the second cover element 76 from falling into the first volume 700 defined by the sidewalls 72. Alternatively or additionally, the second cover element 76 comprises at least one protrusion extending from the second cover element 76, wherein, when the second cover element 76 is mounted on the first cover element 74, the at least one protrusion rests on the first cover element 74. According to one example, the second cover element 76 comprises one protrusion extending along its entire circumference. According to other examples, two or more separate protrusions may be arranged along the circumference of the second cover element 76. The one or more protrusions prevent the second cover element 76 from falling into the first volume 700 defined by the sidewalls 72. Additionally or alternatively, the second cover element 76 may be held in a desired position with respect to the first cover element 74 by means of any kind of suitable holding, retaining, or fastening mechanism.
Once the second cover element 76 has been removed from the first cover element 74, and the opening is accessible, an optical sensor 90 can be arranged distant from the substrate 10 along a vertical axis A, wherein the vertical axis A extends perpendicular to the first surface of the substrate 10 and through the opening in the first cover element 74. That is, the optical sensor 90 may be arranged vertically above the substrate 10 and may be aligned with the opening such that it has an unobstructed view on the substrate 10, and in particular on the components arranged on the substrate 10 that are to be monitored. The optical sensor 90 may be arranged entirely outside of the housing 7, or may be at least partly arranged inside the housing 7. The exact position of the optical sensor 90 in the vertical direction y may depend on the way in which the optical sensor 90 is mounted to the semiconductor module.
Figure 6 schematically illustrates a housing 7 from which the second cover element 76 has been removed. The housing 7 is part of a semiconductor module 100, further comprising a substrate 10 with different components arranged thereon. The semiconductor module 100 further comprises a printed circuit board 60 that is arranged distant from and in parallel to the substrate 10. The printed circuit board 60 is arranged outside of the housing 7, and an optical sensor 90 is attached to the printed circuit board 60. The optical sensor 90 is aligned with the opening in the first cover element 74 such that is has an unobstructed view on the components on the substrate 10 that are to be monitored. In particular, the optical sensor 90 is arranged along a vertical axis A, wherein the vertical axis A extends perpendicular to the first surface of the substrate 10 and through the opening in the first cover element 74.

The printed circuit board 60 may comprise through holes, and one or more of the terminal elements 4 arranged on the substrate 10 may extend from the substrate 10, through the housing 7 to the outside of the housing 7, and further through the through holes provided in the printed circuit board 60. For example, the terminal elements 4 may be soldered to the printed circuit board 60. A mechanical and (optionally) electrical connection between the terminal elements 4 and the printed circuit board 60, however, may also be implemented in any other suitable way. By providing a mechanical connection between the printed circuit board 60 and one or more terminal elements 4, the printed circuit board 60 may be held in a desired position.

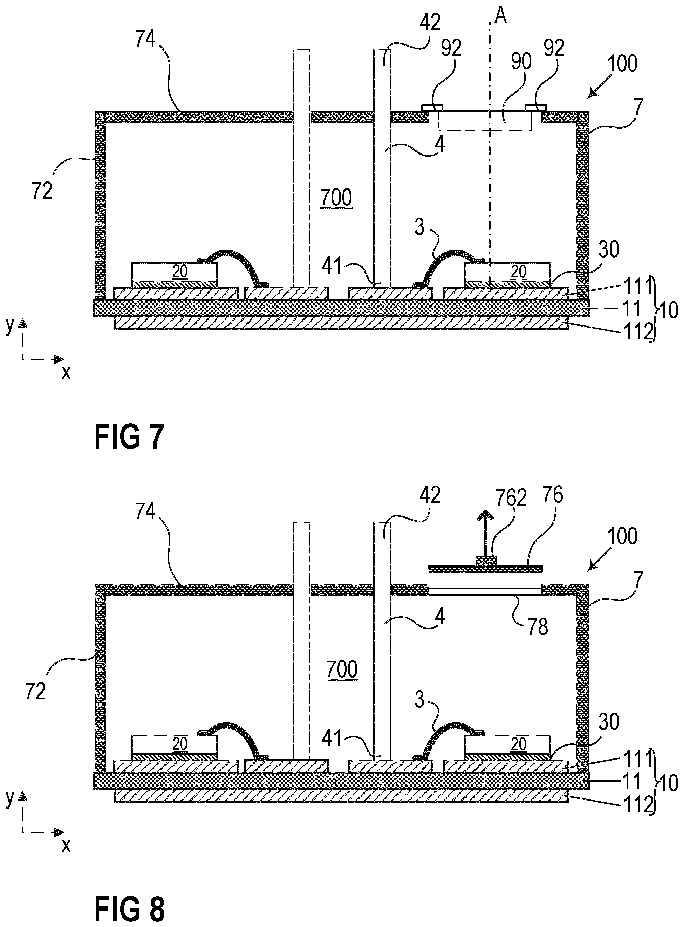

Attaching an optical sensor 90 to a printed circuit board 60, however, is only an example. An optical sensor 90 can be mounted on a semiconductor module 100 in a desired position in any suitable way. Referring to Figure 7, an optical sensor 90 is attached to the first cover element 74 by means of a mounting mechanism 92. The mounting mechanism 92 may be any kind of mechanism that is suitable to attach the optical sensor 90 to the first cover element 74. The mounting mechanism 92 may comprise simple bars, for example. Such bars may be attached to the optical sensor 90 as well as to the first cover element 74, for example, in any suitable way (e.g., gluing, clamping, etc.), thereby holding the optical sensor 90 in a desired position. Similar to what has been described with respect to Figure 6 above, the optical sensor 90 is arranged distant from the substrate 10 along a vertical axis A, wherein the vertical axis A extends perpendicular to the substrate 10 and through the opening in the first cover element 74. That is, the optical sensor 90 is aligned with the opening in the first cover element 74 and is arranged outside of the housing 7 or at least partly inside the housing 7. In this way, it has an unobstructed view on the relevant components arranged on the substrate 10 vertically below the opening.

Similar to conventional housings 7, the first cover element 74 may consist of a non-transparent material, and the second cover element 76 may consist of a non-transparent material. The view on the components that are to be monitored is enabled once the second cover element 76 has been removed from the opening in the first cover element 74. When the second cover element 76 has been removed, the housing 7 is partly open. That is, gasses, liquids or particles may enter the inside of the housing 7 through the opening in the first cover element 74. In some semiconductor modules 100, this may not be desirable. According to further embodiments of the disclosure, therefore, the housing 7 may further comprise a third cover element 78, wherein the third cover element 78 consists of a transparent material. This is schematically illustrated in Figure 8. Contrary to the second cover element 76 which can be removed from the first cover element 74, the third cover element 78 may be permanently attached to the first cover element 74 such that it entirely covers the opening formed in the first cover element 74. When the second cover element 76 is mounted on the first cover element 74, the second cover element 76 entirely covers the third cover element 78. That is, when the second cover element 76 is mounted on the first cover element 74, the housing 7 is non-transparent. The third cover element 78, when the second cover element 76 is mounted on the first cover element 74, is arranged between the second cover element 76 and the volume 700 defined by the sidewalls 72. When the second cover element 76 is removed from the first cover element 74 (indicated by an arrow in Figure 8), the housing 7 becomes partly transparent. An optical sensor 90 may be mounted on the semiconductor module 100 similar to what has been described above. The transparent third cover element 78, when an optical sensor 90 is mounted on the semiconductor module 100, is arranged between the optical sensor 90 and the substrate 10. Due to its transparency, however, the third cover element 78 does not block the view of the optical sensor 90 on the substrate 10. The housing 7, however, remains closed, and gasses, fluids or particles are prevented from entering the inside of the housing 7.

Summarizing the above, a housing 7 for a semiconductor module arrangement 100 comprises sidewalls 72 defining a first volume 700, a first cover element 74 attached to or integrally formed with the sidewalls 72, wherein the first cover element 74 comprises an opening, such that it only partly covers the first volume 700, and a second cover element 76, wherein the second cover element 76 is configured to be removably mounted on the first cover element 74, wherein, when the second cover element 76 is mounted on the first cover element 74, it entirely covers the opening in the first cover element 74.

According to one example, the second cover element 76 may comprise a grasping element 762 configured to be grasped by a user or a robotic gripper arm in order to remove the second cover element 76 from or mount the second cover element 76 on the first cover element 74.

Alternatively or additionally, the first cover element 74 may comprise at least one protrusion extending from the first cover element 74 into the opening such that, when the second cover element 76 is mounted on the first cover element 74, the second cover element 76 rests on the at least one protrusion. Alternatively or additionally, the second cover element 76 may comprise at least one protrusion extending from the second cover element 76 such that, when the second cover element 76 is mounted on the first cover element 74, the at least one protrusion rests on the first cover element 74.

Additionally or alternatively, the housing 7 may further comprise a third cover element 78, wherein the third cover element 78 consists of a transparent material, the third cover element 78 is permanently attached to the first cover element 74 such that it entirely covers the opening formed in the first cover element 74, and, when the second cover element 76 is mounted on the first cover element 74, the second cover element 76 entirely covers the third cover element 78, wherein the third cover element 78 is arranged between the second cover element 76 and the volume defined by the sidewalls 72. The first cover element 74 may consist of a non-transparent material, and the second cover element 76 may consist of a non-transparent material.

A semiconductor module arrangement 100 according to embodiments of the disclosure comprises a substrate 10 having a first surface, and a housing 7 is arranged such that its sidewalls 72 surround at least the first metallization layer 111 of the substrate 10. The housing 7 comprises sidewalls 72 surrounding at least the first metallization layer 111 of the substrate 10 and defining a first volume 700 adjacent to the first surface of the substrate 10, a first cover element 74 attached to or integrally formed with the sidewalls 72, wherein the first cover element 74 comprises an opening, such that it only partly covers the first volume 700, and a second cover element 76, wherein the second cover element 76 is configured to be removably mounted on the first cover element 74, wherein, when the second cover element 76 is mounted on the first cover element 74, it entirely covers the opening in the first cover element 74.
The semiconductor module arrangement may further comprise at least one component arranged on the first surface of the substrate 10, wherein the at least one component comprises at least one of a semiconductor body 20, and an electrical connection 3, wherein the opening in the first cover element 74 is arranged above at least one of the at least one component in a vertical direction y, wherein the vertical direction y is a direction perpendicular to the first surface of the substrate 10.
A method for assembling a semiconductor module arrangement according to embodiments of the disclosure comprises arranging a housing 7 according to any of the embodiments described above such that the sidewalls 72 of the housing 7 surround at least the first metallization layer 111 of a
substrate 10 and define the first volume 700 adjacent to a first surface of the substrate 10, and removing the second cover element 76 from the first cover element 74 such that the opening in the first cover element 74 is uncovered.
The method may further comprise arranging an optical sensor 90 distant from the substrate 10 along a vertical axis A, wherein the vertical axis A extends perpendicular to the first surface of the substrate 10 and through the opening in the first cover element 74. According to one embodiment, arranging an optical sensor 90 distant from the substrate 10 along a vertical axis A may comprise arranging a printed circuit board 60 distant from and in parallel to the substrate 10, wherein the printed circuit board 60 is arranged outside of the housing 7, and wherein the optical sensor 90 is attached to the printed circuit board 60. According to an alternative embodiment, arranging an optical sensor 90 distant from the substrate 10 along a vertical axis A may comprise attaching the optical sensor 90 to the first cover element 74 by means of a mounting mechanism 92.
In the figures, housings with a single opening and a single second cover element 76 are exemplarily illustrated. However, in order to be able to monitor a greater number of components by means of a plurality of optical sensors 90 (e.g., two or more optical sensors 90), more than one opening and more than two second cover elements 76 may be provided. That is, the first cover element 74 may comprise two or more openings, wherein each opening may be covered by means of one of a plurality of second cover elements 76 that may be removably connected to the first cover element 74. It is generally possible that all of a plurality of second cover elements 76 be removed from the first cover element 74, and a separate optical sensor 90 be provided for each of the plurality of openings. It is, however, also possible, even if a housing 7 comprises a plurality of openings and second cover elements 76, that not all of the second cover elements 76 be removed from the first cover element 74. That is, only some of the openings may be made available for monitoring by means of an optical sensor 90. Customers of such housings can remove one or more of the second cover elements 76 and attach a respective optical sensor 90 on demand.

## Claims

1. A housing (7) for a semiconductor module arrangement (100) comprises:
sidewalls (72) defining a first volume (700);
a first cover element (74) attached to or integrally formed with the sidewalls (72), wherein the first cover element (74) comprises an opening, such that it only partly covers the first volume (700); and
a second cover element (76), wherein the second cover element (76) is removably mounted on the first cover element (74) such that it can be removed from the first cover element (74) without destroying any of the first cover element (74) and the second cover element (76), and such that it entirely covers the opening in the first cover element (74).

2. The housing (7) of claim 1, wherein the second cover element (76) comprises a grasping element (762) configured to be grasped by a user or a robotic gripper arm in order to remove the second cover element (76) from or mount the second cover element (76) on the first cover element (74).

3. The housing (7) of claim 1 or 2, wherein
the first cover element (74) comprises at least one protrusion extending from the first cover element (74) into the opening, and wherein, when the second cover element (76) is mounted on the first cover element (74), the second cover element (76) rests on the at least one protrusion, and/or
the second cover element (76) comprises at least one protrusion extending from the second cover element (76), and wherein, when the second cover element (76) is mounted on the first cover element (74), the at least one protrusion rests on the first cover element (74).

4. The housing (7) of any of claims 1 to 3, further comprising a third cover element (78), wherein
the third cover element (78) consists of a transparent material,
the third cover element (78) is permanently attached to the first cover element (74) such that it entirely covers the opening formed in the first cover element (74), and
the second cover element (76) entirely covers the third cover element (78), wherein the third cover element (78) is arranged between the second cover element (76) and the volume defined by the sidewalls (72).

5. The housing (7) of any of the preceding claims, wherein
the first cover element (74) consists of a non-transparent material, and
the second cover element (76) consists of a non-transparent material.

6. A semiconductor module arrangement (100) comprises:
a substrate (10) comprising a dielectric insulation layer (11), a first metallization layer (111) attached to the dielectric insulation layer (11), and a second metallization layer (112) attached to the dielectric insulation layer (11), wherein the dielectric insulation layer (11) is disposed between the first and second metallization layers (111, 112), the substrate (10) having a first surface, the first surface being a top surface of the substrate (10) on which semiconductor bodies (20) and any other components are mounted; and
a housing (7) according to any of claims 1 to 5, wherein the housing (7) is arranged such that its sidewalls (72) surround at least the first metallization layer (111) of the substrate (10), and the first volume is defined adjacent to the first surface of the substrate (10).

7. The semiconductor module arrangement (100) of claim 6, further comprising at least one component arranged on the first surface of the substrate (10), wherein the at least one component comprises at least one of a semiconductor body (20), and an electrical connection (3), wherein the opening in the first cover element (74) is arranged above at least one of the at least one component in a vertical direction (y), wherein the vertical direction (y) is a direction perpendicular to the first surface of the substrate (10).

8. A method for assembling a semiconductor module arrangement (100), the method comprising
arranging a housing (7) according to any of claims 1 to 5 such that the sidewalls (72) of the housing (7) surround a substrate (10) and define the first volume (700) adjacent to a first surface of the substrate (10), and
removing the second cover element (76) from the first cover element (74) such that the opening in the first cover element (74) is uncovered.

9. The method of claim 8, further comprising arranging an optical sensor (90) distant from the substrate (10) along a vertical axis (A), wherein the vertical axis (A) extends perpendicular to the first surface of the substrate (10) and through the opening in the first cover element (74).

10. The method of claim 9, wherein arranging an optical sensor (90) distant from the substrate (10) along a vertical axis (A) comprises arranging a printed circuit board (60) distant from an in parallel to the substrate (10), wherein the printed circuit board (60) is arranged outside of the housing (7), and wherein the optical sensor (90) is attached to the printed circuit board (60).

11. The method of claim 9, wherein arranging an optical sensor (90) distant from the substrate (10) along a vertical axis (A) comprises attaching the optical sensor (90) to the first cover element (74) by means of a mounting mechanism (92).

## Patentansprüche

1. Gehäuse (7) für eine Halbleitermodulanordnung (100), umfassend:
Seitenwände (72), die ein erstes Volumen (700) definieren;
ein erstes Abdeckelement (74), das an den Seitenwänden (72) angebracht oder integral mit diesen ausgebildet ist, wobei das erste Abdeckelement (74) eine Öffnung umfasst, sodass es das erste Volumen (700) nur teilweise bedeckt; und
ein zweites Abdeckelement (76), wobei das zweite Abdeckelement (76) lösbar an dem ersten Abdeckelement (74) montiert ist, sodass es von dem ersten Abdeckelement (74) entfernt werden kann, ohne dass eines von dem ersten Abdeckelement (74) und dem zweiten Abdeckelement (76) zerstört wird, und sodass es die Öffnung in dem ersten Abdeckelement (74) vollständig bedeckt.

2. Gehäuse (7) nach Anspruch 1, wobei das zweite Abdeckelement (76) ein Greifelement (762) umfasst, das dazu ausgebildet ist, von einem Benutzer oder einem Robotergreiferarm ergriffen zu werden, um das zweite Abdeckelement (76) von dem ersten Abdeckelement (74) zu entfernen oder das zweite Abdeckelement (76) daran zu montieren.

3. Gehäuse (7) nach Anspruch 1 oder 2, wobei das erste Abdeckelement (74) mindestens einen Vorsprung umfasst, der sich von dem ersten Abdeckelement (74) in die Öffnung erstreckt, und wobei, wenn das zweite Abdeckelement (76) an dem ersten Abdeckelement (74) montiert ist, das zweite Abdeckelement (76) auf dem mindestens einen Vorsprung aufliegt, und/oder das zweite Abdeckelement (76) mindestens einen Vorsprung umfasst, der sich von dem zweiten Abdeckelement (76) erstreckt, und wobei, wenn das zweite Abdeckelement (76) an dem ersten Abdeckelement (74) montiert ist, der mindestens eine Vorsprung auf dem ersten Abdeckelement (74) aufliegt.

4. Gehäuse (7) nach einem der Ansprüche 1 bis 3, ferner umfassend ein drittes Abdeckelement (78), wobei das dritte Abdeckelement (78) aus einem transparenten Material besteht,
das dritte Abdeckelement (78) dauerhaft an dem ersten Abdeckelement (74) angebracht ist, derart, dass es die in dem ersten Abdeckelement (74) ausgebildete Öffnung vollständig bedeckt, und
das zweite Abdeckelement (76) das dritte Abdeckelement (78) vollständig bedeckt, wobei das dritte Abdeckelement (78) zwischen dem zweiten Abdeckelement (76) und dem durch die Seitenwände (72) definierten Volumen angeordnet ist.

5. Gehäuse (7) nach einem der vorhergehenden Ansprüche, wobei
das erste Abdeckelement (74) aus einem nicht transparenten Material besteht, und
das zweite Abdeckelement (76) aus einem nicht transparenten Material besteht.

6. Halbleitermodulanordnung (100), umfassend:
ein Substrat (10), das eine dielektrische Isolationsschicht (11), eine erste Metallisierungsschicht (111), die an der dielektrischen Isolationsschicht (11) angebracht ist, und eine zweite Metallisierungsschicht (112), die an der dielektrischen Isolationsschicht (11) angebracht ist, umfasst, wobei die dielektrische Isolationsschicht (11) zwischen der ersten und der zweiten Metallisierungsschicht (111, 112) angeordnet ist, wobei das Substrat (10) eine erste Fläche aufweist, wobei die erste Fläche eine obere Fläche des Substrats (10) ist, auf der Halbleiterkörper (20) und beliebige andere Komponenten montiert sind; und
ein Gehäuse (7) nach einem der Ansprüche 1 bis 5, wobei das Gehäuse (7) so angeordnet ist, dass seine Seitenwände (72) mindestens die erste Metallisierungsschicht (111) des Substrats (10) umgeben und das erste Volumen neben der ersten Fläche des Substrats (10) definiert ist.

7. Halbleitermodulanordnung (100) nach Anspruch 6, ferner umfassend mindestens eine Komponente, die auf der ersten Fläche des Substrats (10) angeordnet ist, wobei die mindestens eine Komponente mindestens eines von einem Halbleiterkörper (20) und einer elektrischen Verbindung (3) umfasst, wobei die Öffnung in dem ersten Abdeckelement (74) in einer vertikalen Richtung (y) über mindestens einer der mindestens einen Komponente angeordnet ist, wobei die vertikale Richtung (y) eine Richtung senkrecht zur ersten Fläche des Substrats (10) ist.

8. Verfahren zum Montieren einer Halbleitermodulanordnung (100), wobei das Verfahren Folgendes umfasst:
Anordnen eines Gehäuses (7) nach einem der Ansprüche 1 bis 5 derart, dass die Seitenwände (72) des Gehäuses (7) ein Substrat (10) umgeben und das erste Volumen (700) neben einer ersten Fläche des Substrats (10) definieren, und
Entfernen des zweiten Abdeckelements (76) von dem ersten Abdeckelement (74), sodass die Öffnung in dem ersten Abdeckelement (74) freigelegt wird.

9. Verfahren nach Anspruch 8, ferner umfassend Anordnen eines optischen Sensors (90) entlang einer vertikalen Achse (A) von dem Substrat (10) entfernt, wobei sich die vertikale Achse (A) senkrecht zur ersten Fläche des Substrats (10) und durch die Öffnung in dem ersten Abdeckelement (74) erstreckt.

10. Verfahren nach Anspruch 9, wobei das Anordnen eines optischen Sensors (90) entlang einer vertikalen Achse (A) von dem Substrat (10) entfernt das Anordnen einer Leiterplatte (60) entfernt von und parallel zu dem Substrat (10) umfasst, wobei die Leiterplatte (60) außerhalb des Gehäuses (7) angeordnet ist und wobei der optische Sensor (90) an der Leiterplatte (60) angebracht ist.

11. Verfahren nach Anspruch 9, wobei das Anordnen eines optischen Sensors (90) entlang einer vertikalen Achse (A) von dem Substrat (10) entfernt das Anbringen des optischen Sensors (90) an dem ersten Abdeckelement (74) mittels eines Montagemechanismus (92) umfasst.

## Revendications

1. Un boîtier (7) d'un agencement (100) de module à semiconducteur comprend :
des parois (72) latérales définissant un premier volume (700) ;
un premier élément (74) de recouvrement fixé aux parois (72) latérales ou formé d'une pièce avec celles-ci, dans lequel le premier élément (74) de recouvrement comprend une ouverture, de manière à ce qu'il recouvre seulement en partie le premier volume (700) ; et
un deuxième élément (76) de recouvrement, dans lequel le deuxième élément (76) de recouvrement est monté de manière amovible sur le premier élément (74) de recouvrement de manière à pouvoir être retiré du premier élément (74) de recouvrement sans détruire ni le premier élément (74) de recouvrement ni le deuxième élément (76) de recouvrement, et de manière à recouvrir entièrement l'ouverture dans le premier élément (74) de recouvrement.

2. Le boîtier (7) de la revendication 1, dans lequel le deuxième élément (76) de recouvrement comprend un élément (762) de préhension configuré pour être pris par un utilisateur ou par un bras d'agrippement robotisé, afin de retirer le deuxième élément (76) de recouvrement du deuxième élément (76) de recouvrement sur le premier élément (74) de recouvrement ou de l'y monter.

3. Le boîtier (7) de la revendication 1 ou 2, dans lequel
le premier élément (74) de recouvrement comprend au moins une saillie s'étendant à partir du premier élément (74) de recouvrement dans l'ouverture, et dans lequel, lorsque le deuxième élément (76) de recouvrement est monté sur le premier élément (74) de recouvrement, le deuxième élément (76) de recouvrement sur la au moins une saillie, et/ou
le deuxième élément (76) de recouvrement comprend au moins une saillie s'étendant à partir du deuxième élément (76) de recouvrement, et dans lequel, lorsque le deuxième élément (76) de recouvrement est monté sur le premier élément (74) de recouvrement, la au moins une saillie repose sur le premier élément (74) de recouvrement.

4. Le boîtier (7) de la revendication 1 à 3, comprenant en outre un troisième élément (78) de recouvrement, dans lequel
le troisième élément (78) de recouvrement consiste en un matériau transparent,
le troisième élément (78) de recouvrement est fixé de manière permanente au premier élément (74) de recouvrement de manière à recouvrir entièrement l'ouverture formée dans le premier élément (74) de recouvrement, et
le deuxième élément (76) de recouvrement recouvre entièrement le troisième élément (78) de recouvrement,
dans lequel le troisième élément (78) de recouvrement est disposé entre le deuxième élément (76) de recouvrement et le volume définit par les parois (72) latérales.

5. Le boîtier (7) de l'une quelconque des revendications précédentes, dans lequel
le premier élément (74) de recouvrement consiste en un matériau non transparent, et
le deuxième élément (76) de recouvrement consiste en un matériau non transparent.

6. Un agencement (100) de module à semiconducteur comprend :
un substrat (10) comprenant une couche (11) diélectrique d'isolation, une première couche (111) de métallisation fixée à la couche (11) diélectrique d'isolation, et une deuxième couche (112) de métallisation fixée à la couche (11) diélectrique d'isolation, dans lequel la couche (11) diélectrique d'isolation est disposée entre la première et la deuxième couche (111, 112) de métallisation, le substrat (10) ayant une première surface, la première surface étant une surface de sommet du substrat (10), sur laquelle des corps (20) à semiconducteur et tout autre composant sont montés ; et
un boîtier (7) suivant l'une quelconque des revendications 1 à 5, dans lequel le boîtier (7) est disposé de manière à ce que ses parois (72) latérales entourent au moins la première couche (111) de métallisation du substrat (10), et le premier volume est défini comme voisin de la première surface du substrat (10).

7. L'agencement (100) de module à semiconducteur de la revendication 6, comprenant en outre au moins un composant disposé sur la première surface du substrat (10), dans lequel le au moins un composant comprend au moins l'un d'un corps (20) à semiconducteur et d'une connexion (3) électrique, dans lequel l'ouverture dans le premier élément (74) de recouvrement est agencée au-dessus d'au moins l'un du au moins un composant dans une direction (y) verticale, dans lequel la direction (y) verticale est une direction perpendiculaire à la première surface du substrat (10).

8. Un procédé d'assemblage d'un agencement (100) de module à semiconducteur, le procédé comprenant
disposer un boîtier (7) suivant l'une quelconque des revendications 1 à 5 de manière à ce que les parois (72) latérales du boîtier (7) entourent un substrat (10) et définissent le premier volume (700) voisin d'une première surface du substrat (10), et
retirer le deuxième élément (76) de recouvrement du premier élément (74) de recouvrement de manière à découvrir l'ouverture du premier élément (74) de recouvrement.

9. Le procédé de la revendication 8, comprenant en outre disposer un capteur (90) optique à distance du substrat (10) suivant un axe (A) vertical, dans lequel l'axe (A) vertical s'étend perpendiculairement à la première surface du substrat (10) et dans l'ouverture dans le premier élément (74) de recouvrement.

10. Le procédé de la revendication 9, dans lequel disposer un capteur (90) optique à distance du substrat (10) suivant un axe (A) vertical comprend disposer une plaquette (60) à circuit imprimé à distance du substrat (10) et parallèlement à celui-ci, dans lequel la plaquette (60) à circuit imprimé est disposée à l'extérieur du boîtier (7), et dans lequel le capteur (90) optique est fixé à la plaquette (60) à circuit imprimé.

11. Le procédé de la revendication 9, dans lequel disposer un capteur (90) optique à distance du substrat (10) suivant un axe (A) vertical comprend fixer le capteur (90) optique au premier élément (74) de recouvrement au moyen d'un mécanisme (92) de montage.
